# FASCICULE DE BREVET EUROPEEN

(11) **EP 2 997 607 B1**
(45) Date de publication et mention de la délivrance du brevet: **18.07.2018**
(21) Numéro de dépôt: 14729422.7
(22) Date de dépôt: 13.05.2014
(51) Int. Cl.: H01L 33/18, H01L 27/15, H05B 33/08, H01L 25/16, H01L 33/08, H01L 33/24, H01L 29/73, H01L 29/78, H01L 29/88

(54) **DISPOSITIF OPTOÉLECTRONIQUE ET SON PROCÉDÉ DE FABRICATION**
OPTOELEKTRONISCHE VORRICHTUNG UND VERFAHREN ZU DEREN HERSTELLUNG
OPTOELECTRONIC DEVICE AND METHOD FOR MANUFACTURING SAME

(30) Priorité: 14.05.2013 FR 1354285
(43) Date de publication de la demande: 23.03.2016
(73) Titulaire: Commissariat à l'Energie Atomique et aux Energies Alternatives, 75015 Paris (FR)
(72) Inventeur: TCHELNOKOV, Alexei, F-38240 Meylan (FR); ROBIN, Ivan-Christophe, F-38000 Grenoble (FR); MOUREY, Bruno, F-38500 Coublevie (FR)
(74) Mandataire: Cabinet Beaumont
(86) Numéro de dépôt international: PCT/FR2014/051112
(87) Numéro de publication internationale: WO 2014/184488

(56) Documents cités:
- EP-A2- 2 079 279
- WO-A1-2011/019856
- WO-A1-2012/035243
- WO-A1-2012/068687
- CN-A- 101 106 852
- US-A1- 2006 171 135
- US-A1- 2007 139 928
- US-A1- 2012 161 652
- US-A1- 2013 088 867

## Description

La présente demande de brevet revendique la priorité de la demande de brevet français FR13/54285.

### Domaine

La présente invention concerne de façon générale les matériaux semiconducteurs, les dispositifs à base de matériaux semiconducteurs et leurs procédés de fabrication. La présente invention concerne plus particulièrement les dispositifs comprenant des éléments tridimensionnels, notamment des microfils ou nanofils semiconducteurs.

### Exposé de l'art antérieur

Des exemples de microfils ou nanofils comprenant un matériau semiconducteur sont les microfils ou nanofils à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. De tels microfils ou nanofils permettent la fabrication de dispositifs semiconducteurs tels que des dispositifs optoélectroniques.

Par dispositifs optoélectroniques, on entend des dispositifs adaptés pour effectuer la conversion d'un signal électrique en un rayonnement électromagnétique, et notamment des dispositifs dédiés à l'émission d'un rayonnement électromagnétique.

Des exemples de dispositifs optoélectroniques comprennent des diodes électroluminescentes comprenant des éléments tridimensionnels, notamment des microfils ou nanofils semiconducteurs, formés sur un substrat, comme divulgués par exemple dans WO 2012/035243 A1. En fonctionnement, les microfils ou nanofils sont connectés en parallèle. Chaque diode électroluminescente est théoriquement traversée par un courant ayant la même intensité et émet la même quantité de lumière. Toutefois, les propriétés électriques des microfils ou nanofils peuvent être légèrement différentes d'un fil à l'autre. Certains microfils ou nanofils peuvent alors laisser passer plus de courant que d'autres. Un phénomène d'emballement peut se produire. En effet, les microfils ou nanofils traversés par un courant plus élevé tendent alors à chauffer davantage, ce qui réduit leur résistance et entraîne une augmentation du courant les traversant. Finalement, seule une petite partie de l'ensemble des diodes électroluminescentes participe effectivement à l'émission de lumière.

Un autre exemple est le document WO 2012/068687 A1, qui divulgue un dispositif optoélectronique comprenant des diodes électroluminescentes (DEL) comprenant des éléments semiconducteurs et un composant de limitation de courant, ce composant étant connecté en série avec les éléments semiconducteurs et ayant une résistance qui augmente avec l'intensité du courant. Le document US 2012/0161652 A1 divulgue enfin un appareil émetteur de lumière dans lequel à chaque branche de DEL est connectée, en série, une diode régulatrice de courant afin que, dans chaque branche DEL, le courant soit maintenu constant. Résumé

Ainsi, un mode de réalisation prévoit un dispositif optoélectronique comprenant :
des diodes électroluminescentes comprenant des éléments semiconducteurs, chaque élément semiconducteur comprenant un microfil ou un nanofil ;
des composants de limitation de courant, chaque composant étant connecté en série avec l'un des éléments semiconducteurs et ayant une résistance qui augmente avec l'intensité du courant.
Selon un mode de réalisation, chaque composant comprend au moins des première et deuxième diodes tunnel, la cathode de la première diode tunnel étant connectée à la cathode de la deuxième diode tunnel ou l'anode de la première diode tunnel étant connectée à l'anode de la deuxième diode tunnel.

Selon un mode de réalisation, chaque composant comprend au moins une diode tunnel résonnante.

Selon un mode de réalisation, chaque composant comprend au moins un transistor bipolaire.

Selon un mode de réalisation, chaque composant comprend au moins un transistor MOS.

Selon un mode de réalisation, le dispositif comprend, en outre, pour chaque microfil ou nanofil, une portion isolante entourant une partie du microfil ou nanofil et une portion conductrice entourant la portion isolante.

Selon un mode de réalisation, le dispositif comprend, en outre :
un substrat semiconducteur dopé d'un premier type de conductivité ;
des plots sur une face du substrat, chaque élément semiconducteur étant en contact avec l'un des plots.

Selon un mode de réalisation, les plots sont dopés d'un deuxième type de conductivité opposé au premier type de conductivité, chaque élément semiconducteur étant dopé du premier type de conductivité.

Selon un mode de réalisation, le substrat est en un premier matériau semiconducteur choisi parmi le groupe comprenant le silicium, le germanium, le carbure de silicium, un composé III-V, un composé II-VI et une combinaison de ces composés.

Selon un mode de réalisation, chaque élément semiconducteur comprend au moins une partie comprenant majoritairement un deuxième matériau semiconducteur en contact avec l'un des plots, le matériau semiconducteur étant choisi parmi le groupe comprenant le silicium, le germanium, le carbure de silicium, un composé III-V, un composé II-VI et une combinaison de ces composés.

Selon un mode de réalisation, les plots sont un matériau choisi parmi le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

Selon un mode de réalisation, chaque élément semiconducteur est au moins partiellement recouvert d'une structure semiconductrice adaptée à émettre de la lumière.

Un mode de réalisation prévoit un procédé de fabrication d'un dispositif optoélectronique comprenant les étapes suivantes :
former des diodes électroluminescentes comprenant des éléments semiconducteurs, chaque élément comprenant un microfil ou un nanofil ; et
former des composants de limitation de courant, chaque composant étant connecté en série avec l'un des éléments semiconducteurs.

Selon un mode de réalisation, le procédé comprend, en outre, les étapes suivantes :
former un premier circuit électronique comprenant les diodes électroluminescentes ;
former un deuxième circuit électronique comprenant lesdits composants ; et
fixer le premier circuit électronique au deuxième circuit électronique.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une coupe, partielle et schématique, d'un exemple d'un dispositif optoélectronique à microfils ou nanofils ;
la figure 2 est une coupe, partielle et schématique, d'un mode de réalisation d'un dispositif optoélectronique à microfils ou nanofils comprenant un composant limiteur de courant ;
la figure 3 représente, de façon schématique, la courbe d'évolution de l'intensité du courant traversant un composant à résistance négative en fonction de la tension aux bornes du composant ;
les figures 4 et 5 sont des coupes, partielles et schématiques, de deux modes de réalisation d'un composant à résistance négative ;
la figure 6 représente un circuit électrique équivalent d'une partie d'un mode de réalisation d'un dispositif optoélectronique à microfils ou nanofils comprenant un transistor bipolaire en série avec chaque diode électroluminescente ;
la figure 7 représente des courbes d'évolution du courant de collecteur du transistor bipolaire de la figure 6 en fonction de la tension collecteur-émetteur pour différents courants de base ;
la figure 8 est une coupe, partielle et schématique, d'un mode de réalisation d'un dispositif optoélectronique ayant le circuit électrique équivalent de la figure 6 ;
la figure 9 représente un circuit électrique équivalent d'une partie d'un mode de réalisation d'un dispositif optoélectronique à microfils ou nanofils comprenant un transistor à effet de champ en série avec chaque diode électroluminescente ;
la figure 10 représente des courbes d'évolution du courant drain-source du transistor à effet de champ de la figure 9 en fonction de la tension drain-source pour différentes tensions grille-source ;
la figure 11 est une coupe, partielle et schématique, d'un mode de réalisation d'un dispositif optoélectronique ayant le circuit électrique équivalent de la figure 9 ; et
les figures 12A à 12E sont des coupes, partielles et schématiques, des structures obtenues à des étapes successives d'un mode de réalisation d'un procédé de fabrication d'un dispositif optoélectronique à microfils ou nanofils.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

Dans la suite de la description, lorsque l'on considère la courbe caractéristique d'évolution du courant traversant un composant en fonction de la tension aux bornes du composant, la résistance statique R_{St}^{P} du composant en un point de fonctionnement P de la courbe caractéristique correspondant à une tension U et un courant I est égale au rapport entre la tension U et le courant I au point de fonctionnement P et la résistance dynamique R_{Dy}^{P} du composant au point de fonctionnement P est égale au rapport entre une petite variation dU de la tension autour du point de fonctionnement P et la variation résultante dI du courant autour du point de fonctionnement P. Sauf indication contraire, quand le terme résistance est utilisé seul, il s'agit de la résistance statique.

La présente invention concerne des dispositifs optoélectroniques à éléments tridimensionnels, par exemple des microfils, des nanofils ou des éléments en forme de pyramide. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Les fils sont formés sur un substrat. Le substrat peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, ou un substrat en ZnO. Le substrat peut être en un matériau conducteur, par exemple en métal, ou en un matériau isolant, par exemple en saphir, en verre ou en céramique.

Des plots ou îlots, appelés également par la suite îlots de germination, sont formés sur une face du substrat. Les îlots de germination sont en un matériau favorisant la croissance des fils. Dans le cas d'îlots de germination, un traitement est, en outre, prévu pour protéger les flancs latéraux des îlots de germination et la surface des parties du substrat non recouvertes par les îlots de germination pour former une région diélectrique sur les flancs latéraux des îlots de germination et s'étendant sur et/ou dans le substrat et reliant, pour chaque paire de plots, l'un des plots de la paire à l'autre plot de la paire, les fils ne croissant pas sur la région diélectrique.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant les îlots de germination est choisi de façon à favoriser la croissance des fils selon la même polarité. A titre d'exemple, lorsque les fils comprennent majoritairement un composé III-V, le matériau constituant les îlots de germination est choisi de préférence de façon à favoriser la croissance du composé III-V selon la polarité de l'élément du groupe V. Le composé III-V croît alors selon la polarité de l'élément du groupe V sur les îlots de germination, depuis le sommet de chaque îlot de germination, et ne croît ni sur les flancs latéraux des îlots de germination ni sur le reste du substrat. En outre, les inventeurs ont mis en évidence que chaque fil croît alors selon une polarité sensiblement constante dans la totalité du fil. Lorsque les fils comprennent majoritairement un composé II-VI, le matériau constituant les îlots de germination est choisi de préférence de façon à favoriser la croissance du composé II-VI selon la polarité de l'élément du groupe VI. Le composé II-VI croît alors selon la polarité de l'élément du groupe VI sur les îlots de germination, depuis le sommet de chaque îlot de germination, et ne croît ni sur les flancs latéraux des îlots de germination ni sur le reste du substrat.

Dans le cas d'un composé III-V dans lequel l'élément du groupe V est l'azote, le matériau composant les îlots peut être un matériau favorisant la croissance d'un fil selon la polarité N. A titre d'exemple, les îlots peuvent être réalisés en nitrure d'aluminium (AlN), en nitrure de bore (BN), en carbure de silicium (SiC), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), ou en une combinaison de ceux-ci et de leurs composés nitrurés. De préférence, le matériau composant les îlots de germination est le nitrure d'aluminium.

Le procédé de croissance des fils peut être un procédé du type dépôt chimique en phase vapeur (CVD, sigle anglais pour Chemical Vapor Déposition) ou dépôt chimique en phase vapeur organométallique (MOCVD, acronyme anglais pour Metal-Organic Chemical Vapor Déposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Déposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), la tertiarybutylphosphine (TBP), l'arsine (AsH₃), ou la diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur du silicium est le silane (SiH₄).

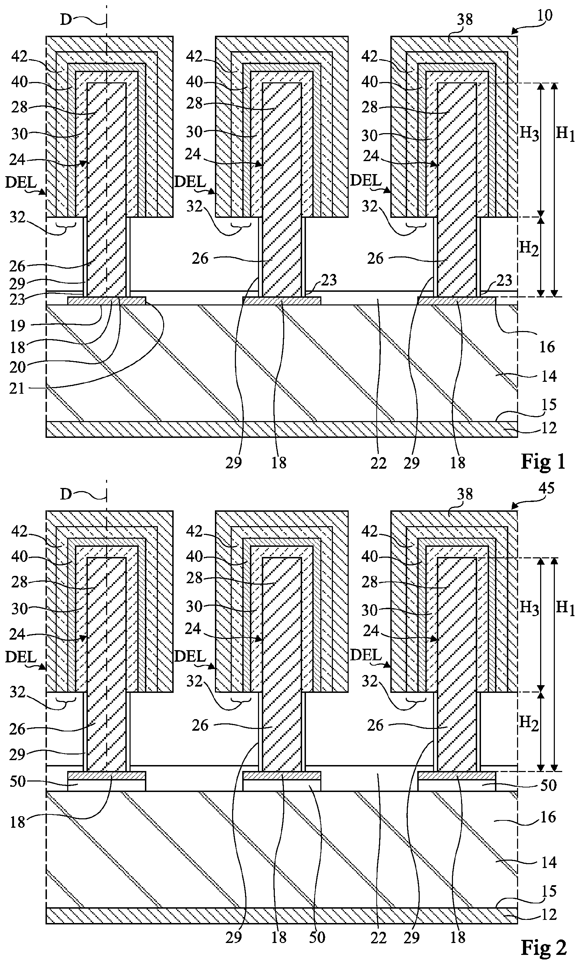

La figure 1 est une coupe, partielle et schématique, d'un exemple d'un dispositif optoélectronique 10 réalisé à partir de fils tels que décrits précédemment et adapté à l'émission d'un rayonnement électromagnétique.

Le dispositif 10 comprend, du bas vers le haut en figure 1 :
une première électrode de polarisation 12 ;
un substrat semiconducteur 14 comprenant des faces opposées 15 et 16, la face 15 étant au contact de l'électrode 12 ;
des îlots de germination 18 favorisant la croissance de fils et disposés sur la face 16, chaque îlot 18 comprenant une face inférieure 19 en contact avec la face 16 du substrat 14, une face supérieure 20, opposée à la face 19 et à distance de la face 19, et des faces latérales 21, ou flancs latéraux, reliant la face inférieure 19 à la face supérieure 20 ;
une couche isolante 22 s'étendant entre les îlots de germination 18 sur la face 16 du substrat 14, la couche isolante 22 recouvrant partiellement chaque îlot de germination 18 et comprenant des ouvertures 23 qui expose chacune une partie du sommet 20 de l'un des îlots de germination 18 ;
des fils 24 (trois fils étant représentés) de hauteur H₁, chaque fil 24 étant en contact avec la face 20 de l'un des îlots 18, chaque fil 24 comprenant une portion inférieure 26, de hauteur H₂, en contact avec l'îlot 18 et une portion supérieure 28, de hauteur H₃, en contact avec la portion inférieure 26 ;
une couche passivante 29 recouvrant la périphérie de chaque portion inférieure 26 ;
une couche active 30 recouvrant chaque portion supérieure 28 ;
une couche semiconductrice 32 ou un empilement de couches semiconductrices recouvrant chaque couche active 30 ; et
une couche de seconde électrode 38 recouvrant chaque couche semiconductrice 32.

Le substrat 14 est, par exemple, un substrat semiconducteur, tel qu'un substrat en silicium. Le substrat 14 est dopé d'un premier type de conductivité, par exemple dopé de type N. Les faces 15 et 16 peuvent être planes et parallèles. La face 16 du substrat 14 peut être une face <100>.

L'électrode 12 peut correspondre à une couche conductrice qui s'étend sur la face 15 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

Les îlots 18 sont situés sur la face 16 de sorte qu'ils soient en saillie par rapport à la face 16. Le sommet 20 de chaque îlot 18 est donc dans un plan différent de la face 16. Chaque îlot 18 a une texturation préférentielle et, lorsque le matériau composant chaque îlot comprend un alliage d'au moins deux éléments, une polarité préférentielle. Par texturation préférentielle, on entend que les cristaux qui composent les îlots 18 ont une direction de croissance privilégiée qui est la même pour tous les îlots 18. Par polarité préférentielle, on entend que les îlots 18 ont sensiblement tous la même polarité. Ceci signifie que lorsque le matériau composant chaque îlot comprend un alliage d'au moins deux éléments, lorsque le matériau est coupé dans un plan perpendiculaire à la direction de croissance privilégiée du matériau, la surface exposée comprend essentiellement des atomes du même élément pour chaque îlot 18. Chaque îlot 18 présente le même type de conductivité, par exemple de type N, que le substrat 14 afin de réduire la résistance d'interface entre les îlots 18 et le substrat 14. Chaque îlot 18 peut avoir une forme quelconque, par exemple rectangulaire, polygonale, circulaire, carrée ou ovale.

Les îlots 18 ont, par exemple, une épaisseur comprise entre 1 et 100 nanomètres, de préférence comprise entre 1 et 60 nanomètres, plus préférentiellement entre 1 nm et 10 nm, encore plus préférentiellement entre 2 nm et 5 nm. Les centres de deux îlots 18 adjacents peuvent être distants de 0,5 µm à 10 µm et de préférence de 1,5 à 4 µm. A titre d'exemple, les îlots 18 peuvent être régulièrement répartis sur le substrat 14. A titre d'exemple, les îlots 18 peuvent être répartis selon un réseau hexagonal.

La couche isolante 22 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant. A titre d'exemple, l'épaisseur de la couche isolante 22 est comprise entre 5 nm et 100 nm, par exemple égale à environ 30 nm.

Chaque fil 24 a une structure semiconductrice allongée selon un axe D sensiblement perpendiculaire à la face 16. Chaque fil 24 peut avoir une forme générale cylindrique allongée à base hexagonale. Le diamètre moyen de chaque fil 24 peut être compris entre 50 nm et 2,5 µm et la hauteur H₁ de chaque fil 24 peut être comprise entre 250 nm et 50 µm.

La portion inférieure 26 de chaque fil 24 est principalement constituée du composé III-N, par exemple du nitrure de gallium, dopé du premier type de conductivité, par exemple au silicium. Le pourtour de la portion inférieure 26 est recouvert par la couche 29 de diélectrique, par exemple du SiN, sur la hauteur H₂ depuis l'extrémité de la portion inférieure 26 au contact avec l'îlot 18 associé. La hauteur H₂ peut être comprise entre 100 nm et 25 µm. La couche de matériau diélectrique 29 a une épaisseur comprise entre une monocouche atomique et 100 nm, de préférence entre une monocouche atomique et 10 nm.

La portion supérieure 28 de chaque fil 24 est, par exemple, au moins partiellement réalisée dans un composé III-N, par exemple du GaN. La portion supérieure 28 peut être dopée du premier type de conductivité, ou ne pas être intentionnellement dopée. La portion supérieure 28 s'étend sur la hauteur H₃ qui peut être comprise entre 100 nm et 25 µm.

Dans le cas d'un fil composé principalement de GaN, la structure cristalline du fil peut être du type wurtzite, le fil s'étendant selon l'axe C. La structure cristalline du fil peut également être du type cubique.

La couche active 30 est la couche depuis laquelle est émise la majorité du rayonnement fourni par le dispositif 10. Selon un exemple, la couche active 30 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 32 ou l'empilement de couches semiconductrices 32 permet la formation d'une jonction P-N ou P-I-N avec la couche active 30 et/ou la portion supérieure 28. Elle permet l'injection de trous dans la couche active 30 via l'électrode 38.

L'empilement de couches semiconductrices 32 peut comprendre une couche de blocage d'électrons 40 formée d'un alliage ternaire, par exemple en nitrure de gallium et d'aluminium (AlGaN) ou en nitrure d'indium et d'aluminium (AlInN) en contact avec la couche active 30 et une couche supplémentaire 42, pour assurer un bon contact électrique entre la deuxième électrode 38 et la couche active 30, par exemple en nitrure de gallium (GaN) en contact avec la couche de blocage d'électrons 40 et avec l'électrode 38. La couche semiconductrice 42 est dopée du type de conductivité opposé à celui de la portion 28, par exemple dopée de type P. La couche de blocage d'électrons 40 peut être de même type de conductivité que la couche semiconductrice 42.

La deuxième électrode 38 est adaptée pour polariser la couche active 30 de chaque fil 24 et laisser passer le rayonnement électromagnétique émis par les fils 24. Le matériau formant l'électrode 38 peut être un matériau transparent et conducteur tel que de l'oxyde d'indium-étain (ou ITO, acronyme anglais pour Indium Tin Oxide), de l'oxyde de zinc dopé à l'aluminium ou du graphène.

Le dispositif optoélectronique 10 comprend généralement une couche conductrice ou semiconductrice qui est connectée à l'ensemble des deuxièmes électrodes 38. Les fils 24 sont donc connectés en parallèle. L'ensemble formé par le fil 24, et l'empilement associé de la couche active 30, des couches semiconductrices 32 et de l'électrode 38 forme une diode électroluminescente DEL. En théorie, les diodes électroluminescentes DEL ont une structure et des propriétés électriques identiques. Comme la même tension est appliquée entre les électrodes 38 et l'électrode 12, un courant ayant la même intensité traverse chaque fil 24 de sorte que toutes les diodes électroluminescentes émettent la même quantité de lumière. Toutefois, en pratique, les propriétés électriques des diodes électroluminescentes peuvent être légèrement différentes. Il s'agit, par exemple, de la tension de coude, de la résistance série ou de la qualité des contacts électriques de chaque diode électroluminescente. Les courants traversant les fils 24 ne sont donc généralement pas exactement identiques. Ceci crée un déséquilibre qui s'auto-amplifie. En effet, un fil 24 traversé par un courant d'intensité plus élevée tend à chauffer davantage. Ceci entraîne une diminution de la résistance du fil 24 et donc une nouvelle augmentation du courant qui le traverse. Finalement, la majorité du courant ne passe effectivement que dans une petite partie de l'ensemble des nanofils ou microfils. Un nombre réduit de diodes électroluminescentes participe effectivement à l'émission de lumière, les autres diodes électroluminescentes pouvant rester sensiblement éteintes.

Ainsi, un objet d'un mode de réalisation est de pallier au moins en partie les inconvénients des dispositifs optoélectroniques, notamment à microfils ou nanofils, et de leurs procédés de fabrication décrits précédemment.

Un autre objet d'un mode de réalisation est que chaque diode électroluminescente du dispositif optoélectronique est traversée par un courant ayant sensiblement la même intensité d'une diode électroluminescente à l'autre.

Un autre objet d'un mode de réalisation est que chaque diode électroluminescente de l'ensemble des diodes électroluminescentes connectées en parallèle émet sensiblement la même quantité de lumière.

Un autre objet d'un mode de réalisation est que les diodes électroluminescentes en matériau semiconducteur puissent être formées à une échelle industrielle et à bas coût.

Selon l'invention, on prévoit d'utiliser, en série avec chaque diode électroluminescente, un composant électronique à base de matériaux semiconducteurs jouant le rôle d'un limiteur de courant. Selon l'invention, il s'agit d'un composant électronique ayant une résistance, potentiellement non linéaire, qui augmente avec l'intensité du courant.

La figure 2 est une coupe, partielle et schématique, d'un mode de réalisation d'un dispositif optoélectronique 45 réalisé à partir de fils tel que décrit précédemment et adapté à l'émission d'un rayonnement électromagnétique.

Le dispositif optoélectronique 45 comprend l'ensemble des éléments du dispositif optoélectronique 10 décrit précédemment en relation avec la figure 1 et comprend, en outre, pour chaque fil 24, un composant électronique 50 disposé au pied du fil 24, le composant 50 ayant une résistance non linéaire qui, sur au moins une plage de courant, augmente avec l'intensité du courant. De ce fait, si l'intensité du courant traversant un fil tend à augmenter, ceci entraîne une augmentation de la résistance du composant 50 associé au fil 24 et donc une diminution de l'intensité du courant traversant le fil. L'augmentation de la résistance de chaque composant électronique 50 lors d'une augmentation du courant est choisie de façon avantageuse pour que les courants traversant les diodes électroluminescentes restent sensiblement égaux et constants. Les non-linéarités des résistances du composant 50 permettent donc d'homogénéiser les courants traversant les diodes électroluminescentes. La totalité des diodes électroluminescentes DEL du dispositif optoélectronique 45 participe donc à l'émission d'un rayonnement.

Dans le mode de réalisation représenté en figure 2, pour chaque fil 24, le composant 50 est disposé entre l'îlot de germination 18 et le substrat 14. Selon une variante, le composant 50 peut être disposé entre l'îlot de germination 18 et le fil 24. Selon une autre variante, l'îlot de germination 18 et/ou la portion inférieure 26 du fil peuvent faire partie du composant 50.

Selon un mode de réalisation, le composant 50 comprend une caractéristique courant-tension qui comporte une partie à résistance négative.

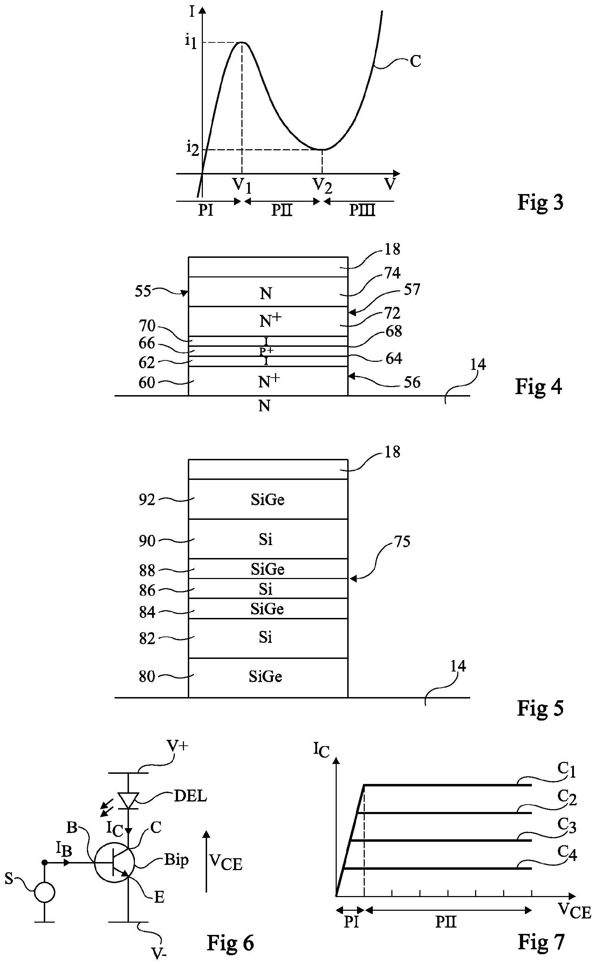

La figure 3 représente un exemple de courbe d'évolution C de l'intensité (I) du courant traversant le composant 50 en fonction de la tension (V) aux bornes du composant 50. La courbe C comprend :
une première phase PI, lorsque la tension V est comprise entre 0 V et V₁, dans laquelle une augmentation de la tension V entraîne une augmentation de l'intensité I du courant ;
une deuxième phase PII lorsque la tension V est comprise entre V₁ et V₂, dans laquelle une augmentation de la tension V entraîne une diminution de l'intensité I du courant ; et
une troisième phase PIII, lorsque la tension V est supérieure à V₂, dans laquelle une augmentation de la tension V entraîne une augmentation de l'intensité I du courant.

Les caractéristiques du composant 50 sont choisies de sorte que, à la tension de fonctionnement du dispositif optoélectronique, la tension aux bornes du composant 50 soit située entre V₁ et V₂. La résistance du composant 50 augmente alors bien avec l'intensité du courant entre V₁ et V₂.

Selon un mode de réalisation, le composant 50 comprend au moins une diode tunnel.

La figure 4 est une coupe, partielle et schématique, d'un mode de réalisation du composant 50 dans lequel le composant 50 comprend un empilement 55 de deux diodes tunnel.

Une diode tunnel est une jonction semiconductrice PN dans laquelle les couches semiconductrices P et N sont fortement dopées, par exemple de l'ordre de 10¹⁹ ou 10²⁰ atomes/cm³, et dans laquelle l'épaisseur de la couche de charge d'espace est faible, par exemple inférieure à quelques dizaines de nanomètres, par exemple de l'ordre de 10 nm ou inférieure à 10 nm.

Selon le présent mode de réalisation, l'empilement 55 comprend deux diodes tunnel 56 et 57 connectées en série.

La première diode tunnel 56 comprend successivement depuis le substrat 14 et jusqu'à l'îlot de germination 18 :
- une couche semiconductrice 60 dopée de type N. La couche 60 a, par exemple, une concentration de dopants d'environ 2.10¹⁹ atomes/cm³ et une épaisseur d'environ 100 nm ;
- une couche semiconductrice 62, non volontairement dopée. La couche 62 a, par exemple, une épaisseur d'environ 5 nm ; et
- une couche semiconductrice 66 dopée de type P. La couche 66 a, par exemple, une concentration de dopants d'environ 3.10¹⁹ atomes/cm³ et une épaisseur d'environ 8 nm.

La diode tunnel 56 peut comprendre, entre la couche semiconductrice 62 et la couche semiconductrice 66, une face 64 dopée de type P par delta-dopage. Le dopage de la face 64 est, par exemple, d'environ 10¹⁴ atomes/cm².

La deuxième diode tunnel 57, réalisée sur la première diode tunnel 56, comprend successivement :
- la couche semiconductrice 66 mentionnée précédemment ;
- une couche semiconductrice 70, non volontairement dopée. La couche 70 a, par exemple, une épaisseur d'environ 4 nm ; et
- une couche semiconductrice 72 dopée de type N. La couche 72 a, par exemple, une concentration de dopants d'environ 2.10¹⁹ atomes/cm³ et une épaisseur d'environ 100 nm.

La diode tunnel 57 peut comprendre, entre la couche semiconductrice 66 et la couche semiconductrice 70, une face 68 dopée de type P par delta-dopage. Le dopage de la face 68 est, par exemple, d'environ 10¹⁴ atomes/cm².

Ainsi, les deux diodes tunnel 56, 57 sont en série l'une avec l'autre, et disposées de manière à être "tête-bêche" en comportant en commun la couche semiconductrice 66. La deuxième diode tunnel 57 est ainsi connectée en série avec la première diode tunnel 56 avec une polarité inversée.

L'empilement 55 peut, en outre, comporter une couche semiconductrice 74, dopée de type N, recouvrant la couche semiconductrice 72. La couche 74 a, par exemple, une concentration de dopants d'environ 10¹⁸ atomes/cm³ et une épaisseur d'environ 100 nm. Cette couche forme une couche tampon sur laquelle est réalisé l'îlot de germination 18.

Les couches 60, 62, 66, 70, 72, 74 sont, par exemple, en silicium.

A titre de variante, dans le cas où le substrat 14 et la portion inférieure 26 de chaque fil sont dopés de type P, l'empilement de diodes tunnel 55 peut avoir la structure représentée à la figure 4 à la différence que les polarités N et P des couches sont inversées.

La figure 5 est une coupe, partielle et schématique, d'un mode de réalisation du composant 50 dans lequel le composant 50 comprend une diode tunnel résonnante 75. Selon le présent mode de réalisation, la diode tunnel résonnante 75 comprend successivement depuis le substrat 14 et jusqu'à l'îlot de germination 18 :
- une couche 80 d'un alliage de silicium et de germanium. La couche 80 a, par exemple, une épaisseur d'environ 100 nm et une concentration de dopants, par exemple de type N, d'environ 10¹⁸ atomes/cm³ ou plus ;
- une couche 82 de silicium, non volontairement dopée. La couche 82 a, par exemple, une épaisseur d'environ 15 nm ;
- une couche 84 non volontairement dopée, d'un alliage de silicium et de germanium. La couche 84 a, par exemple, une épaisseur d'environ 7,5 nm ;
- une couche 86 de silicium, non volontairement dopée. La couche 86 a, par exemple, une épaisseur d'environ 5 nm ;
- une couche 88 non volontairement dopée, d'un alliage de silicium et de germanium. La couche 88 a, par exemple, une épaisseur d'environ 7,5 nm ;
- une couche 90 de silicium, non volontairement dopée. La couche 90 a, par exemple, une épaisseur d'environ 15 nm ; et
- une couche 92 d'un alliage de silicium et de germanium. La couche 92 a, par exemple, une épaisseur d'environ 100 nm et une concentration de dopants, par exemple de type N, d'environ 10¹⁸ atomes/cm³ ou plus.

La figure 6 représente un schéma électrique équivalent d'un autre mode de réalisation dans lequel le composant 50 comprend un transistor bipolaire Bip monté en série avec la diode électroluminescente DEL. Les sources de potentiel V+ et V-correspondent aux sources de potentiel destinées à être reliées, en fonctionnement, aux électrodes 12 et 38. Le collecteur C du transistor Bip est connecté à la cathode de la diode DEL, l'émetteur E du transistor Bip est connecté à la source de tension V-et la base B est connectée à une source de courant S. A titre de variante, la polarisation de la base B peut être réalisée par tout type de circuit de polarisation, notamment par une source de tension en série avec une résistance ou un pont diviseur de tension prévu entre les sources de potentiel V+ et V-.

Le transistor bipolaire Bip est monté en "émetteur commun". En fonctionnement, la base B du transistor est polarisée de façon que le transistor bipolaire fonctionne en régime linéaire.

La figure 7 représente, de façon schématique, des courbes d'évolution C₁, C₂, C₃ et C₄ du courant I_{C} au collecteur du transistor bipolaire Bip en fonction de la tension V_{CE} entre le collecteur et l'émetteur pour différentes valeurs du courant de base I_{B}. Chaque courbe comprend une première partie PI, appelée régime de saturation, dans laquelle le courant de collecteur I_{C} croît fortement avec la tension V_{CE}, suivie d'une deuxième partie PII, appelée régime linéaire, dans laquelle le courant de collecteur I_{C} ne dépend que très faiblement de la tension V_{CE}. En régime linéaire, la résistance dynamique du transistor Bip est très grande et le transistor agit comme un stabilisateur de courant. La résistance du transistor bipolaire Bip augmente alors bien avec l'intensité du courant en régime linéaire. La valeur du courant stabilisé est contrôlée par le courant de base.

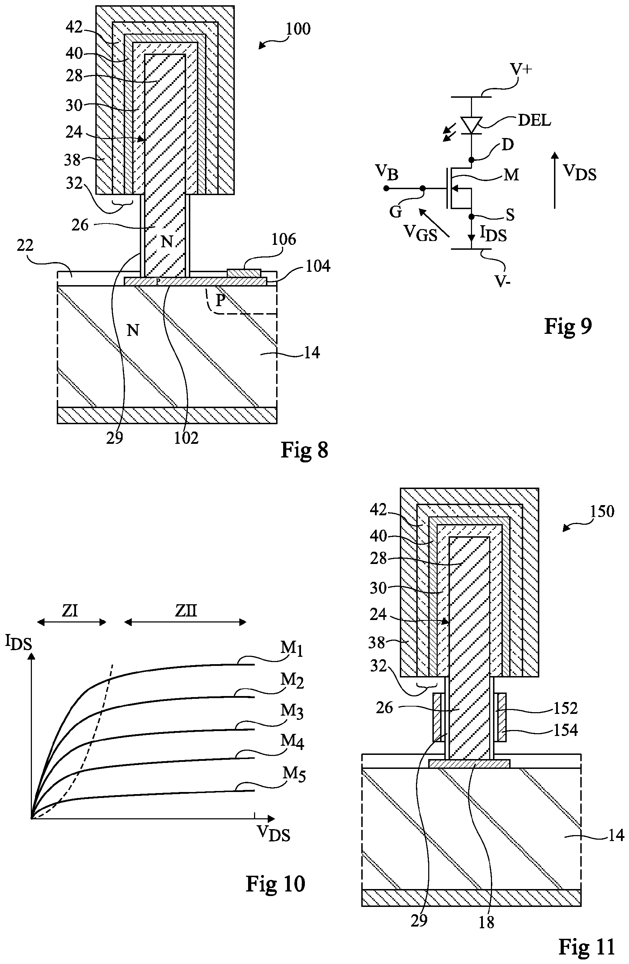

La figure 8 est une coupe, partielle et schématique, d'un mode de réalisation selon l'invention d'un dispositif optoélectronique 100 réalisé à partir de fils tels que décrits précédemment, adapté à l'émission d'un rayonnement électromagnétique et pour lequel le schéma électrique équivalent associé à chaque fil est représenté en figure 6.

Le dispositif optoélectronique 100 comprend l'ensemble des éléments du dispositif optoélectronique 10 décrit précédemment en relation avec la figure 1 à la différence que chaque îlot de germination 18 du dispositif optoélectronique 10, qui a le même type de dopants que le substrat 14 et la portion inférieure 26 du fil 24, est remplacé par un îlot de germination 102 ayant un type de dopants opposé au type de dopants du substrat 14 et de la portion inférieure 26 du fil 24. De ce fait, si le substrat 14 et la portion inférieure 26 sont dopés de type N, l'îlot de germination 102 est dopé de type P. Les matériaux constituant l'îlot de germination 102 peuvent être identiques à ceux décrits précédemment pour l'îlot de germination 18.

A titre d'exemple, la concentration de dopants du substrat 14 est de 10¹⁸ à 10²⁰ atomes/cm³, la concentration de dopants de la portion inférieure 26 du fil est de 10¹⁸ à 10¹⁹ atomes/cm³ et la concentration de dopants de l'îlot de germination 102 est de 10¹⁷ à 10¹⁸ atomes/cm³.

L'îlot de germination 102 peut comprendre une portion 104 s'étendant latéralement. Un plot conducteur 106 peut être prévu au contact de la portion 104. Le plot conducteur 106 est destiné à être relié à la source de courant S. Une région 104 dopée de type P peut être prévue sous la portion 104 de l'îlot de germination 102 pour l'isoler du reste du substrat 14.

Le substrat 14 correspond à l'émetteur E du transistor bipolaire Bip, l'îlot de germination 102 correspond à la base B du transistor bipolaire Bip et la portion inférieure 26 du fil 24 correspond au collecteur C du transistor bipolaire Bip.

A titre d'exemple, pour un dispositif optoélectronique 100 pour lequel le substrat 14 est en silicium dopé de type N à 5.10¹⁹ atomes/cm³, l'îlot de germination 102 est en carbure de silicium dopé de type P à 10¹⁷ atomes/cm³ et la portion inférieure 26 du nanofil en GaN est dopée de type N à 5.10¹⁸ atomes/cm³, et avec un courant de base I_{B} de l'ordre du nanoampère, le courant de collecteur I_{C} est sensiblement stable à 2 microampères pour une tension émetteur-collecteur supérieure à 0,3 V.

La figure 9 représente un schéma électrique équivalent d'un autre mode de réalisation dans lequel le composant 50 comprend un transistor M à effet de champ à grille métal-oxyde, ou transistor MOS, en série avec la diode électroluminescente DEL. Le drain D du transistor M est relié à la cathode de la diode DEL et la source S du transistor M est reliée à la source de potentiel V-. La grille du transistor MOS est reliée à une source d'un potentiel de référence V_{B}. Le transistor M est monté en "source commune". En fonctionnement, la grille G du transistor M est polarisée de façon que le transistor M fonctionne en régime de saturation.

La figure 10 représente, de façon schématique, des courbes d'évolution M₁, M₂, M₃, M₄ et M₅ du courant drain-source I_{DS} du transistor M en fonction de la tension V_{DS} entre le drain et la source du transistor M pour différentes valeurs de la tension V_{GS} entre la grille et la source. Chaque courbe comprend une première partie ZI, appelée régime linéaire, dans laquelle le courant drain-source I_{DS} croît fortement avec la tension V_{DS}, suivie d'une deuxième partie ZII, appelée régime de saturation, dans laquelle le courant drain-source I_{DS} ne dépend que faiblement de la tension V_{DS}. En régime de saturation, la résistance dynamique du transistor M est très grande et le transistor agit comme un stabilisateur de courant. La résistance du transistor M augmente alors bien avec l'intensité du courant en régime de saturation. La valeur du courant stabilisé est contrôlée par la tension grille-source.

La figure 11 est une coupe, partielle et schématique, d'un mode de réalisation selon l'invention d'un dispositif optoélectronique 150 réalisé à partir de fils tel que décrit précédemment et adapté à l'émission d'un rayonnement électromagnétique, et pour lequel le schéma électrique équivalent associé à chaque fil est représenté en figure 9.

Le dispositif optoélectronique 150 comprend l'ensemble des éléments du dispositif optoélectronique 10 décrit précédemment en relation avec la figure 1 et comprend, en outre, une portion isolante 152 autour de la portion inférieure 26 de chaque fil 24, et une portion conductrice 154 autour de la portion isolante 152. La portion conductrice 154 est destinée à être reliée à la source de potentiel V_{B}. A titre de variante, dans le cas où l'épaisseur de la couche isolante 29 est suffisante, la portion isolante 152 peut ne pas être présente.

La partie de la portion inférieure 26 qui est entourée de la portion isolante 152 correspond au canal du transistor M. Le substrat 14, l'îlot de germination 18 et la partie de la portion inférieure 26 au contact de l'îlot de germination 18 et qui n'est pas entourée de la portion isolante 152 correspond à la source D du transistor M. La portion supérieure 28 du fil 24 et la partie de la portion inférieure 26 du fil 24 qui est au contact de la portion supérieure 28 et qui n'est pas entourée de la portion isolante 152 correspond au drain D du transistor M. La portion conductrice 154 correspond à la grille G du transistor M.

A titre d'exemple, pour un dispositif optoélectronique 150 pour lequel la portion inférieure 26 du nanofil en GaN est dopée de type N à 5.10¹⁸ atomes/cm³ et a un diamètre de 1 µm, pour lequel l'oxyde de grille 152 est en oxyde d'hafnium HfO₂, a une épaisseur de 3 nm et s'étend sur une hauteur de fil de 500 nm, on obtient une stabilisation du courant drain-source I_{DS} à 1 µA pour une tension drain-source de 3,5 V lorsqu'une tension négative de 10 V est appliquée à la grille 154.

Dans les modes de réalisation décrits précédemment, les composants 50 sont prévus au pied des fils 24. Ils sont donc réalisés avant la formation des fils 24 ou en partie pendant la formation des fils 24. Selon un autre mode de réalisation, les diodes électroluminescentes sont réalisées sur un premier support et les composants 50 jouant le rôle de limiteurs de courant sont réalisés sur un deuxième support différent du premier support. Le premier support est alors fixé au deuxième support de façon que chaque composant jouant le rôle d'un limiteur de courant soit connecté en série avec l'une des diodes électroluminescentes. Le premier ou le deuxième support peut ensuite être supprimé.

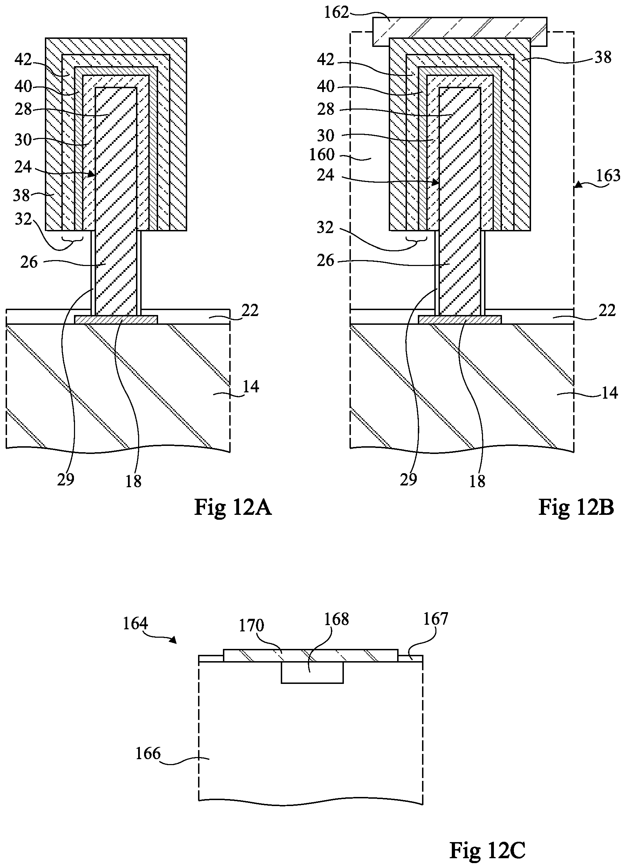

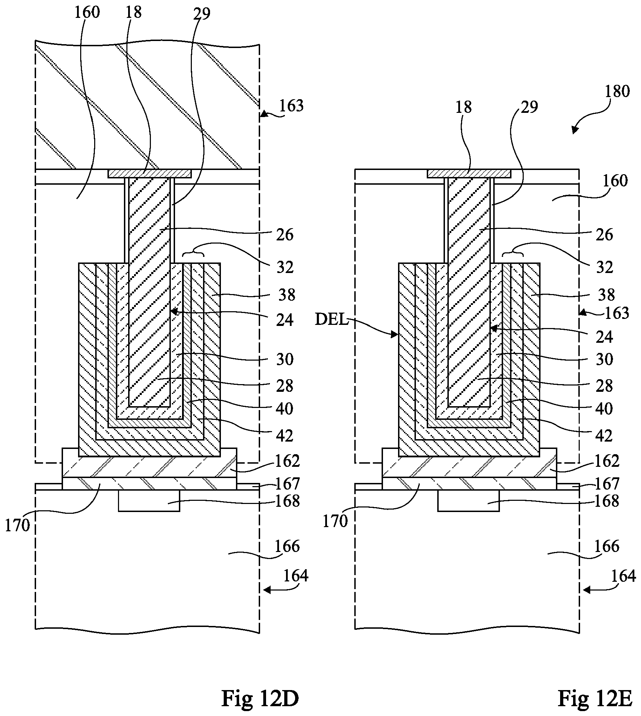

Les figures 12A à 12E illustrent les structures obtenues à des étapes d'un mode de réalisation d'un procédé de fabrication d'un dispositif optoélectronique mettant en oeuvre deux supports distincts. Le mode de réalisation du procédé de fabrication comprend les étapes suivantes :
(1) formation sur le substrat 14, pour chaque fil 24, de l'îlot de germination 18, du fil 24, de la couche active, 30, des couches semiconductrices 32 et de l'électrode 38 (figure 12A) .
(2) formation d'une portion isolante 160 qui s'étend sur toute la hauteur du fil 24 et formation d'un plot conducteur 162 en contact avec l'électrode 38 au sommet du fil 24 (figure 12B). La portion isolante 160 peut être en oxyde de silicium ou en nitrure de silicium. Le plot conducteur 162 peut être en ITO, en nickel, en argent, ou peut correspondre à une structure multicouche comprenant, par exemple, une couche de cuivre recouverte d'une couche de nickel, d'argent ou d'aluminium. Un premier circuit électronique 163 est ainsi obtenu.
(3) formation, simultanément à l'étape (1) et/ou (2), d'un deuxième circuit électronique 164 (figure 12C). Le circuit électronique 164 comprend un support 166 recouvert d'une couche isolante 167. Le circuit 164 comprend, en outre, pour chaque fil 24, un composant 168 jouant le rôle d'un limiteur de courant, et un plot conducteur 170 en surface du support 166 et relié au composant 168. Le support 166 peut être en un matériau semiconducteur, par exemple en silicium. Le composant 168 peut correspondre à l'un des exemples de composant 50 décrits précédemment, notamment une diode tunnel, un transistor bipolaire ou un transistor MOS. La couche isolante 167 peut être en oxyde de silicium ou en nitrure de silicium. Le plot conducteur 170 peut être en or ou peut correspondre à une structure multicouche comprenant, par exemple, une couche de cuivre recouverte d'une couche de nickel, d'argent ou d'aluminium.
(4) fixation, par exemple par collage moléculaire ou par brasage, du premier circuit électronique 163 au deuxième circuit électronique 164 (figure 12D) de sorte que chaque plot conducteur 162 est connecté à l'un des plots conducteurs 170.
(5) retrait du substrat 14 (figure 12E) du circuit électronique 163, par exemple par polissage mécano-chimique de façon à exposer les îlots de germination 18. Un dispositif optoélectronique 180 est ainsi obtenu. Le procédé peut comprendre des étapes successives de formation d'une électrode transparente ou semi-transparente, par exemple en ITO, reliée aux îlots de germination 18 et d'une électrode sur la face du substrat 166 opposée aux diodes électroluminescentes DEL. Les diodes électroluminescentes DEL du dispositif optoélectronique 180 émettent de la lumière vers le haut en figure 12E. A titre de variante, l'étape de polissage mécano-chimique peut être réalisée de façon à exposer les portions inférieures 26 des fils 24. Une électrode transparente ou semi-transparente, par exemple en ITO, peut alors être déposée au contact des portions inférieures 26.

Des modes de réalisation particuliers de la présente invention ont été décrits. Diverses variantes et modifications apparaîtront à l'homme de l'art.

En effet, bien que dans les modes de réalisation décrits précédemment, la couche active 30 entoure la portion supérieure 28 de chaque fil 24, la couche active peut recouvrir seulement le sommet du fil.

En outre, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est clair que la deuxième électrode peut être prévue du côté de la première face.

De plus, bien que, dans les modes de réalisation décrits précédemment, chaque fil 24 comprenne une portion passivée 26, à la base du fil en contact avec le sommet 20 d'un îlot de germination 18, cette portion passivée 26 peut ne pas être présente.

## Revendications

1. Dispositif optoélectronique (45 ; 100 ; 150 ; 180) comprenant :
des diodes électroluminescentes (DEL) comprenant des éléments semiconducteurs (24), chaque élément semiconducteur (24) comprenant un microfil ou un nanofil,
**caractérisé en ce qu'**il comprend, en outre, des composants (50 ; 168) de limitation de courant, chaque composant étant connecté en série avec l'un des éléments semiconducteurs et ayant une résistance qui augmente avec l'intensité du courant.

2. Dispositif optoélectronique selon la revendication 1, dans lequel chaque composant (50) comprend au moins des première et deuxième diodes tunnel, la cathode de la première diode tunnel étant connectée à la cathode de la deuxième diode tunnel ou l'anode de la première diode tunnel étant connectée à l'anode de la deuxième diode tunnel.

3. Dispositif optoélectronique selon la revendication 1, dans lequel chaque composant (50) comprend au moins une diode tunnel résonnante.

4. Dispositif optoélectronique selon la revendication 1, dans lequel chaque composant (50) comprend au moins un transistor bipolaire.

5. Dispositif optoélectronique selon la revendication 1, dans lequel chaque composant (50) comprend au moins un transistor MOS.

6. Dispositif optoélectronique selon l'une quelconque des revendications 1 à 5, comprenant, en outre, pour chaque microfil ou nanofil, une portion isolante (152) entourant une partie du microfil ou nanofil et une portion conductrice (154) entourant la portion isolante.

7. Dispositif optoélectronique selon l'une quelconque des revendications 1 à 6, comprenant, en outre :
un substrat (14) semiconducteur dopé d'un premier type de conductivité ;
des plots (18 ; 102) sur une face (16) du substrat, chaque élément semiconducteur (24) étant en contact avec l'un des plots.

8. Dispositif optoélectronique selon la revendication 7, dans lequel les plots (102) sont dopés d'un deuxième type de conductivité opposé au premier type de conductivité, chaque élément semiconducteur (24) étant dopé du premier type de conductivité.

9. Dispositif optoélectronique selon la revendication 7, dans lequel le substrat (14) est en un premier matériau semiconducteur choisi parmi le groupe comprenant le silicium, le germanium, le carbure de silicium, un composé III-V, un composé II-VI et une combinaison de ces composés.

10. Dispositif optoélectronique selon l'une quelconque des revendications 1 à 9, dans lequel chaque élément semiconducteur (24) comprend au moins une partie (26, 28) comprenant majoritairement un deuxième matériau semiconducteur en contact avec l'un des plots (18 ; 102), le matériau semiconducteur étant choisi parmi le groupe comprenant le silicium, le germanium, le carbure de silicium, un composé III-V, un composé II-VI et une combinaison de ces composés.

11. Dispositif optoélectronique selon la revendication 7, dans lequel les plots (18 ; 102) sont un matériau choisi parmi le groupe comprenant le nitrure d'aluminium, le nitrure de bore, le carbure de silicium, le nitrure de magnésium, le nitrure de gallium et de magnésium, ou en une combinaison de ceux-ci et de leurs composés nitrurés.

12. Dispositif optoélectronique selon l'une quelconque des revendications 1 à 11, dans lequel chaque élément semiconducteur (24) est au moins partiellement recouvert d'une structure (30) semiconductrice adaptée à émettre de la lumière.

13. Procédé de fabrication d'un dispositif optoélectronique (45 ; 100 ; 150 ; 180) comprenant l'étape de former des diodes électroluminescentes (DEL) comprenant des éléments semiconducteurs (24), chaque élément semiconduteur (24) comprenant un microfil ou un nanofil,
**caractérisé en ce qu'**il comprend, en outre, l'étape de former des composants (50 ; 168) de limitation de courant, chaque composant étant connecté en série avec l'un des éléments semiconducteurs et ayant une résistance qui augmente avec l'intensité du courant.

14. Procédé selon la revendication 13, comprenant, en outre, les étapes suivantes :
former un premier circuit électronique (163) comprenant les diodes électroluminescentes (DEL) ;
former un deuxième circuit électronique (164) comprenant lesdits composants (168) ; et
fixer le premier circuit électronique au deuxième circuit électronique.

## Patentansprüche

1. Eine optoelektronische Vorrichtung (45; 100; 150; 180), die Folgendes aufweist:
Licht-emittierende Dioden (DEL), die Halbleiterelemente (24) aufweisen, wobei jedes Halbleiterelement (24) einen Mikrodraht und einen Nanodraht aufweist,
**dadurch gekennzeichnet, dass** sie ferner strombegrenzende Komponenten (50; 168) aufweist, wobei jede Komponente mit einem der Halbleiterelemente in Reihe geschaltet ist und einen Widerstand besitzt, welcher mit der Stromintensität zunimmt.

2. Optoelektronische Vorrichtung nach Anspruch 1, wobei jede Komponente (50) wenigstens erste und zweite Tunneldioden aufweist, wobei die Kathode der ersten Tunneldiode mit der Kathode der zweiten Tunneldiode verbunden ist oder die Anode der ersten Tunneldiode mit der Anode der zweiten Tunneldiode verbunden ist.

3. Optoelektronische Vorrichtung nach Anspruch 1, wobei jede Komponente (50) wenigstens eine Resonanztunneldiode aufweist.

4. Optoelektronische Vorrichtung nach Anspruch 1, wobei jede Komponente (50) wenigstens einen bipolaren Transistor aufweist.

5. Optoelektronische Vorrichtung nach Anspruch 1, wobei jede Komponente (50) wenigstens einen MOS-Transistor aufweist.

6. Optoelektronische Vorrichtung nach einem der Ansprüche 1 bis 5, die ferner für jeden Mikrodraht oder Nanodraht ein Isolierteil (152) aufweist, das einen Teil des Mikrodrahtes oder Nanodrahtes umgibt, und ein Leiterteil (154), das das Isolierteil umgibt.

7. Optoelektronische Vorrichtung nach einem der Ansprüche 1 bis 6, die ferner Folgendes aufweist:
ein dotiertes Halbleitersubstrat (14) eines ersten Leitfähigkeitstyps;
Pads (18; 102) an der Oberfläche (16) des Substrats, wobei jedes Halbleiterelement (24) in Kontakt mit einem der Pads ist.

8. Optoelektronische Vorrichtung nach Anspruch 7, wobei die Pads (102) mit einem zweiten Leitfähigkeitstyp dotiert sind, der entgegengesetzt zu dem ersten Leitfähigkeitstyp ist, wobei jedes Halbleiterelement (24) mit dem ersten Leitfähigkeitstyp dotiert ist.

9. Optoelektronische Vorrichtung nach Anspruch 7, wobei das Substrat (14) aus einem ersten Halbleitermaterial hergestellt ist, das ausgewählt ist aus der Gruppe, die Folgendes aufweist: Silizium, Germanium, Siliziumcarbid, einem III-V-Verbund, einem II-VI-Verbund und einer Kombination dieser Verbindungen.

10. Optoelektronische Vorrichtung nach einem der Ansprüche 1 bis 9, wobei jedes Halbleiterelement (24) wenigstens ein Teil (26, 28) aufweist, der hauptsächlich ein zweites Halbleitermaterial in Kontakt mit einem der Pads (18; 102) aufweist, wobei das Halbleitermaterial ausgewählt ist aus der Gruppe, die Folgendes aufweist: Silizium, Germanium, Siliziumcarbid, einem III-V-Verbund, einem II-VI-Verbund und einer Kombination dieser Verbindungen.

11. Optoelektronische Vorrichtung nach Anspruch 7, wobei die Pads (18; 102) aus einem Material hergestellt sind, die ausgewählt sind aus der Gruppe, die Folgendes aufweist: Aluminiumnitrid, Bornitrid, Siliziumcarbid, Magnesiumnitrid, Magnesiumgalliumnitrid oder einer Kombination davon und ihrer Nitridverbindungen.

12. Optoelektronische Vorrichtung nach einem der Ansprüche 1 bis 11, wobei jedes Halbleiterelement (24) wenigstens teilweise mit einer Halbleiterstruktur (30) abgedeckt ist, welche geeignet ist, Licht zu emittieren.

13. Ein Verfahren zur Herstellung einer optoelektronischen Vorrichtung (45; 100; 150; 180), die den Schritt des Formens von Licht-emittierenden Dioden (DEL) aufweist, welche Halbleiterelemente (24) aufweisen, wobei jedes Halbleiterelement (24) einen Mikrodraht oder einen Nanodraht aufweist,
**dadurch gekennzeichnet, dass** es ferner den Schritt des Formens von strombegrenzenden Komponenten (50; 168) aufweist, wobei jede Komponente mit einem der Halbleiterelemente in Reihe geschaltet ist und einen Widerstand besitzt, welcher mit der Stromintensität zunimmt.

14. Verfahren nach Anspruch 13, das ferner folgende Schritte aufweist:
Formen einer ersten elektronischen Schaltung (163), die Licht-emittierende Dioden (DEL) aufweist;
Formen einer zweiten elektronischen Schaltung (164), die Komponenten (168) aufweist; und
Anbringen der ersten elektronischen Schaltung an die zweite elektronische Schaltung.

## Claims

1. An optoelectronic device (45; 100; 150; 180) comprising:
light-emitting diodes (DEL) comprising semiconductor elements (24), each semiconductor element (24) comprising a microwire or a nanowire,
**characterized in that** it further comprises current-limiting components (50; 168), each component being series-connected with one of the semiconductor elements and having a resistance which increases along with the current intensity.

2. The optoelectronic device of claim 1, wherein each component (50) comprises at least first and second tunnel diodes, the cathode of the first tunnel diode being connected to the cathode of the second tunnel diode or the anode of the first tunnel diode being connected to the anode of the second tunnel diode.

3. The optoelectronic device of claim 1, wherein each component (50) comprises at least one resonant tunnel diode.

4. The optoelectronic device of claim 1, wherein each component (50) comprises at least one bipolar transistor.

5. The optoelectronic device of claim 1, wherein each component (50) comprises at least one MOS transistor.

6. The optoelectronic device of any of claims 1 to 5, further comprising, for each microwire or nanowire, an insulating portion (152) surrounding a portion of the microwire or nanowire and a conductive portion (154) surrounding the insulating portion.

7. The optoelectronic device of any of claims 1 to 6, further comprising:
a doped semiconductor substrate (14) of a first conductivity type;
pads (18; 102) on a surface (16) of the substrate, each semiconductor element (24) being in contact with one of the pads.

8. The optoelectronic device of claim 7, wherein the pads (102) are doped with a second conductivity type opposite to the first conductivity type, each semiconductor element (24) being doped with the first conductivity type.

9. The optoelectronic device of claim 7, wherein the substrate (14) is made of a first semiconductor material selected from the group comprising silicon, germanium, silicon carbide, a III-V compound, a II-VI compound, and a combination of these compounds.

10. The optoelectronic device of any of claims 1 to 9, wherein each semiconductor element (24) comprises at least a portion (26, 28) mainly comprising a second semiconductor material in contact with one of the pads (18; 102), the semiconductor material being selected from the group comprising silicon, germanium, silicon carbide, a III-V compound, a II-VI compound, and a combination of these compounds.

11. The optoelectronic device of claim 7, wherein the pads (18; 102) are made of a material selected from the group comprising aluminum nitride, boron nitride, silicon carbide, magnesium nitride, magnesium gallium nitride, or of a combination thereof and of their nitrided compounds.

12. The optoelectronic device of any of claims 1 to 11, wherein each semiconductor element (24) is at least partially covered with a semiconductor structure (30) capable of emitting light.

13. A method of manufacturing an optoelectronic device (45; 100; 150; 180) comprising the step of forming light-emitting diodes (DEL) comprising semiconductor elements (24), each semiconductor element (24) comprising a microwire or a nanowire,
**characterized in that** it further comprises the step of forming current-limiting components (50; 168), each component being series-connected with one of the semiconductor elements and having a resistance which increases along with the current intensity.

14. The method of claim 13, further comprising the steps of:
forming a first electronic circuit (163) comprising the light-emitting diodes (DEL);
forming a second electronic circuit (164) comprising said components (168); and
attaching the first electronic circuit to the second electronic circuit.
